# EUROPEAN PATENT APPLICATION

(11) **EP 0 607 106 A1**
(43) Date of publication of application: **20.07.1994**
(21) Application number: 94830006.6
(22) Date of filing: 12.01.1994
(51) Int. Cl.: G03F 7/20

(54) **Manufacturing process of improved photosensitive printing plates**

(30) Priority: 12.01.1993 IT MI930023
(71) Applicant: De Caria, Riccardo, Basiglio, Milano (IT)
(72) Inventor: De Caria, Riccardo, Basiglio, Milano (IT)
(74) Representative: Aimi, Luciano

(57) **Abstract**

The photosensitive plate is obtained by introducing the resinous photosensitive composition into a bag made from transparent film and by placing thereafter the thus obtained bag between two parallel pressure plates to achieve the planarity of the two surfaces of the bag, and then subjecting the resulting plane envelope to the action of light with the interposition of a suitable negative. The use of the bag according to the invention allows to avoid all the conventional operations of preparation of the printing plates.

## Description

The present invention concerns a process for the preparation of photosensitive printing plates and in particular the production of transparent bags containing the photosensitive resinous composition to be subjected to the action of light for the resin curing in the transparent areas of the interposed negative. The invention concerns the transparent resin bags thus obtained too.

It is known that the preparation of plates or matrices for many printing processes presently implies various manufacturing steps, wherein a layer of photosensitive material is applied, generally by hand or in some cases by centrifugation, on a support plate made from metal or a plastic material, usually previously cleaned from the grease and made rough, which layer, after drying up, is checked to detect possible defects or irregularities. In particular, a commonly used process requires laying on a glass plate the negative from which the plate is to be obtained; laying a transparent protective film on the negative; forming a peripheral containment ridge, for example made from a profile of adhesive expanded material around the image; spreading the photosensitive liquid within the containment ridge by hand or by means of a wiping blade; laying a base film on the liquid to support the plate shoulder; pressing the liquid sandwich thus obtained by means of a second glass plate parallel to the first one; exposing the base film to an ultraviolet light source to polimerize the plate shoulder; exposing to an ultraviolet light source, through the negative, to polimerize the illuminated areas on the printing plate, thus curing them; and finally a finishing process.

Obviously, these various manufacturing steps involve a considerable loss of time as well as some drawbacks deriving from, for example, the manual handling of the photosensitive liquid composition, which must not be applied in an either insufficient or excessive amount and which, moreover, may be irritating or however may be a source of trouble whenever it comes in touch with the skin of the handler.

An object of the present invention is to provide a manufacturing process of photosensitive printing plates ready to be subjected to the action of the light coming from a negative for the polimerization and curing in the corresponding exposed areas.

Another object of the present invention is to provide a pre-packed photosetting composition, in the form of flexible transparent containers ready to be exposed to the light coming from a negative.

The present invention will now be described in greater detail referring to the annexed drawings, wherein is shown a particular non-limiting embodiment of the subject-matter of the present invention.
Fig. 1schematically illustrates a preparation system of printing plates according to the prior art; and
Fig.2 schematically illustrates an embodiment of the process according to the present invention and of a printing plate thus obtained.

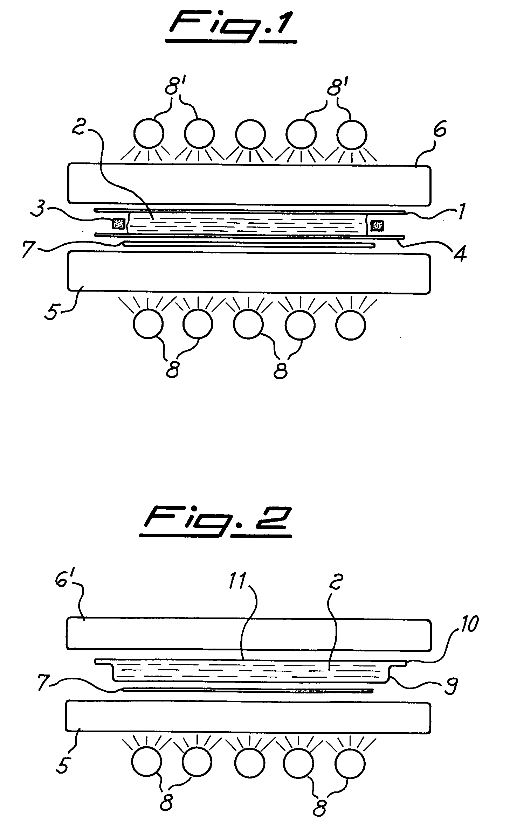

As there is seen in fig.1, the process presently used implies the utilization of a base film 1 on which a layer of photosensitive composition of adequate thickness is spread, in an amount approximately allowed by a peripheral containment ridge 3 and by the application of a protective film 4; the thus obtained sandwich assembly is inserted between two plane parallel plates 5 and 6 made from glass or a transparent plastic material, wherein the lower plate 5 is fixed and the negative carrying the inscriptions or the figures to be reproduced is placed thereon, whereas the upper plate 6 is vertically movable so that it can be brought near the lower plate 5 so as to exert the desired pressure on the assembly of the interposed materials 1, 2, 3, 4 and 7. Below and above the transparent plates 5 and 6, respectively, light sources 8 and 8' are placed in order to carry out the polimerization and curing in the form of a film of the upper surface layer of the photosensitive composition 2 and parallelly the polimerization and curing of the photosensitive composition 2 at the transparent areas of negative 7 on the opposite side.

The process according to the present invention, whose final step is schematically illustrated in fig.2, provides for the photosensitive composition 2 being introduced, by means of suitable packing machines available on the market, in a flat pocket or bag 9 made from transparent thermoplastic film, which, once filled, is thermosealed after the evacuation of the air possibly present therein. The thus obtained bag of the intended size, everytime corresponding to the area to be printed, obviously does not have a definite shape, since it may take, according to the orientation it is given, any conformation dictated by the gravity law on the liquid composition contained therein; however, once it is properly laid on a plane surface and pressed by means of another upper plane surface parallel to the first one, it will take the shape of a layer having the thickness allowed by the containment walls. Thus, it can be placed between the transparent plates 5 and 6 of the prior art, after having interposed a negative 7, and it can be directly subjected, without further handling, to the action of light sources 8 and 8', thereby achieving the curing of composition 2 in the desired areas in much the same way as in the prior art previously described.

Once the desired curing is over, it is sufficient to tear the protective envelope 9 and subject the resulting printing plate to the usual cleaning or washing step in the areas not struck by the light, in order to obtain the printing plate ready for use.

Another embodiment of the present invention provides for the packaging of the photosensitive composition 2, according to the procedure previously described, into an envelope of transparent film 9 whose cross-section has the shape shown in fig.2, according to which the projecting edges 10 obtained by thermosealing, possibly with a flat transparent sheet 11 stiffer than film 9, give a preferential flat development conformation to the resulting envelope. This envelope 9, 10, 11 can thus be subjected, directly after the packaging, to the action of light sources placed on the side of sheet 11, in order to achieve the curing of a continuous surface layer which will act as a support. After this treatment, the envelope containing the photosensitive composition 2 is placed on the usual transparent plate 5, after interposing negative 7, and subjected to the flattening pressure of an upper plate 6', which in this case may also be opaque, thanks to the pre-existence of the continuous supporting layer, so that the lower light sources 8 are sufficient for the polimerization and curing of composition 2 at the transparent areas of negative 7.

A step common to all the procedures for filling the flexible bags according to the present invention provides for the bag being subjected with the proper orientation, once it is filled and closed by thermosealing, to the action of rollers which are run along its surface so as to push the remaining air bubble, if any, towards a suitable sharp point, such as for instance a needle, which pierces film 9, so that the air pressed by the rollers can come out completely. The small hole thus made, is then easily closed by a drop of glue or in another suitable way.

## Claims

1. A process for the production of printing plates made from photosetting resin, characterized in that a liquid resinous photosensitive composition (2) is pre-packed in transparent flexible envelopes (9) shaped as a flat pocket or bag, from which the remaining air is then evacuated; the filled bags are placed on a negative (7), laid on a rigid transparent plate (5), and pressed by an upper parallel rigid plate (6') and the sandwich assembly (5, 7, 9, 6') is subjected to the action of lower (8) and upper (8') light sources to cure the resin (2) in the desired areas; the resulting printing plates are finally extracted from said bags (9) and subjected to washing in a known way.

2. A process for the production of printing plates made from photosetting resin according to claim 1, characterized in that said filled bags (9, 10, 11) are exposed to the action of light on one side just after the packaging.

3. Printing plates pre-packed in a transparent flexible envelope, obtained through the process according to claim 1 or 2.
